# EUROPÄISCHE PATENTANMELDUNG

(11) **EP 0 615 130 A2**
(43) Veröffentlichungstag der Anmeldung: **14.09.1994**
(21) Anmeldenummer: 93111640.4
(22) Anmeldetag: 21.07.1993
(51) Int. Cl.: G01R 1/04

(54) **Abdeckgehäuse**

(30) Priorität: 09.03.1993 DE 9303412 U
(71) Anmelder: HEINRICH BAUMGARTEN KG SPEZIALFABRIK FÜR BESCHLAGTEILE, D-57290 Neunkirchen (DE)
(72) Erfinder: Baumgarten, Gerd-Diethard, D-57234 Wilnsdorf-Wilden (DE)
(74) Vertreter: Missling, Arne, Dipl.-Ing.

(57) **Zusammenfassung**

Abdeckgehäuse für elektrische Meß- oder Zählgeräte erfordern im allgemeinen eine durchsichtige Frontseite zum Ablesen einer Meßskale oder eines Zählwerkes; dienen derartige Meß- oder Zählgeräte der Preisgestaltung beim Energieverbrauch oder dergleichen, dann muß dafür gesorgt werden, daß der durchsichtige Einsatz nicht entfernt werden kann. Bei elektrischen Stromzählern dienen dazu Platten aus Glas oder durchsichtigem Thermoplast, die im Abdeckgehäuse verklebt oder nicht verklebt arretiert sind. Wesentlich einfacher ist es erfindungsgemäß, wenn eine solche glasklare Platte direkt in das Abdeckgehäuse aus einem thermoplastischen Kunststoff eingespritzt wird. Ein solches Gehäuse läßt sich viel rationeller fertigen, ist absolut staubdicht und kann bei entsprechender Gestaltung der Verbindung zwischen dem thermoplastischen Kunststoff und dem zumeist aus einem duroplastischen Werkstoff bestehenden Abdeckgehäuse auch absolut eingriffssicher gestaltet werden.

## Beschreibung

Die Erfindung betrifft ein Abdeckgehäuse aus einem duroplastischen, dielektrischen Werkstoff, beispielsweise aus Phenolharz-Formmasse, zum Überfangen eines elektrischen Meß- oder Zählgerätes, mit einer durchsichtigen Frontseite zum Ablesen einer Meßskale oder eines Zählwerkes, insbesondere an einem Verbrauchszähler für elektrischen Strom.

In einem derartigen Abdeckgehäuse ist üblicherweise in der Frontseite ein Sichtfenster aus Glas oder aus durchsichtigem Thermoplast nachträglich eingefügt, das bei der Montage entweder zunächst mit einem Kleber oder einer Dichtmasse an den Kontaktflächen zwischen Fensterplatte und Duroplastgehäuse versehen oder ohne Kleber (meist bei Thermoplastscheiben) nur lose positioniert wird. Bei der Benutzung von aushärtenden Klebe- oder Dichtmassen müssen dabei Lösungsmittel verwendet werden, die bis zum vollständigen Abbinden gesundheitsgefährdend sind und am Arbeitsplatz eine aufwendige Absaugung und Belüftung erforderlich machen.

Die Sichtfenster, ob geklebt oder nicht geklebt, werden dann mit Federscheiben oder ähnlich wirkenden Halteelementen arretiert, beispielsweise durch angeformte Stifte oder dergleichen. Die Arretierung bei geklebten Sichtfenstern ist notwendig, um auf die Dicht- oder Klebemasse einen konstanten Druck während der Aushärte- oder Trockenzeit auszuüben. Nach dem Aushärten (mehrere Stunden) sind die Halteelemente nicht mehr notwendig. Bei nicht geklebten Sichtfenstern sind entsprechend mehr Halteelemente erforderlich.

Voraussetzung für eine einwandfreie Verbindung zwischen dem Abdeckgehäuse und dem Sichtfenster ist eine genau ebene Anlagefläche, so daß das Sichtfenster beim Spannen der Federringe oder dergleichen Bauteile nicht unter Spannung gerät oder sogar zerbricht. Die Anforderungen an die Ebenheit des Gehäuseanschlages sind deshalb sehr hoch und verursachen gegebenenfalls erheblichen Ausschuß, weil auch das Abdeckgehäuse selbst nicht ohne Verzug herstellbar ist.

Die Erfindung hat sich deshalb die Aufgabe gestellt, ein Abdeckgehäuse der eingangs näher bezeichneten Art so mit einem durchsichtigen Einsatz auf der Frontseite auszurüsten, daß es auch dann vollwertig verwendbar ist, wenn es in gewissem Umfang nach der Entformung verzogen ist.

Erfindungsgemäß wird die Aufgabe dadurch gelöst, daß in der Frontseite eine Ausnehmung mit einer glasklaren Platte aus thermoplastischem Kunststoff wie beispielsweise Makrolon oder Plexiglas verschlossen ist, die in diese Frontseite, die Ausnehmung verschließend, eingespritzt ist. Hierdurch wird erreicht, daß eine absolut dichte Verbindung zwischen Abdeckgehäuse und Platte gewährleistet ist. Dabei werden an die befaßte Begrenzung der Ausnehmung keine besonders hohen Anforderungen hinsichtlich ihrer Ebenheit gestellt. Eine zusätzliche Halterung der Platte entfällt dabei völlig.

Eine sichere Verankerung der Platte in dem Abdeckgehäuse läßt sich erreichen, wenn eine Berandung der Ausnehmung mit an dem Abdeckgehäuse angeformten, die Platte verankernden Haltestücken versehen ist, die von dem überspritzten Randbereich der Platte eingeschlossen sind und eine formschlüssige Arretierung bilden.

In einer weiteren Ausbildung der Erfindung ist die Platte in der Ausnehmung so arretiert, daR sie daraus weder entfernbar noch wiedereinsetzbar ist, ohne daß die Platte und/oder das Abdeckgehäuse dabei sichtbar beschädigt oder zerstört werden. Auf diese Weise ist sichergestellt, daß beispielsweise an einem der Preisberechnung dienenden Verbrauchszähler für elektrischen Strom von Unbefugten keine Manipulationen am Zählwerk durchgeführt werden können, ohne einen derartigen Eingriff erkennen zu können. Dabei kann die Berandung der Ausnehmung in einfacher Weise aus Rippen und/oder Nuten bestehen, die von dem thermoplastischen Kunststoff der eingespritzten Platte überdeckt sind. Zur Erleichterung des Benutzers kann die Platte im Bereich der abzulesenden Meßskale oder des Zählwerkes mit einer angeformten Lupe versehen sein, mit deren Hilfe die Ablesewerte vergrößert abgebildet werden.

Ganz besonders vorteilhaft ist es, wenn die Platte eine Beschriftung, beispielsweise die Meßskale für das Meß- oder Zählgerät, aufweist, die dabei auf der Innenseite der Platte vorgesehen und erhaben zu deren Oberfläche vorgesehen sein kann. Die Benutzung der Beschriftung wird erleichtert, wenn sie von der übrigen Platte farblich abgehoben ist.

Durch die Erfindung wird die Aufgabe in überraschend einfacher Weise gelöst. Sie bildet auch die Grundlage für eine gegenüber dem Stand der Technik wesentlich leistungsfähigere Herstellung, wobei es durchaus möglich ist, das Gesamtgehäuse einschließlich der Platte in einem einzigen Arbeitsgang an verschiedenen Spritzstationen durchzuführen. Es hat sich gezeigt, daR die Berandung der Ausnehmungen nicht entgratet werden muß, was bisher unverzichtbar war und einen erheblichen, auch manuellen, Arbeitsaufwand erforderte. Dabei ist die Raumausnutzung besser, so daß die Längenausdehnung des Abdeckgehäuses in der Achse der Platte verkürzt werden kann. Besonders vorteilhaft ist die Anordnung von Beschriftungen des Meß- und Zählgerätes in der Platte; bei diesem sonst erforderliche separate Beschriftungen oder Zifferblätter können entfallen und werden bei der Herstellung der Platte ohne weiteres gleich mit realisiert.

Die Erfindung wird nachfolgend anhand der Zeichnung an einem Ausführungsbeispiel näher erläutert. Es Zeigen
- Fig. 1: einen Längsschnitt durch ein erfindungsgemäßes Abdeckgehäuse und
- Fig. 2: eine Einzelheit A aus Fig. 1, stark vergrößert.

Ein Abdeckgehäuse 1 gemäß der Erfindung besteht im wesentlichen aus einem (im allgemeinen etwa quaderförmigen) Corpus 11 aus Phenolharz-Formmasse, der an seiner Rückseite 12 an dem Gehäuse des Verbrauchszählers befestigt ist. Dazu dienen mehrere Arretierkeile 13, die einstückig an dem Corpus 11 angeformt sind und in bekannter Weise eine Spannleiste hinterfangen, die aber in der Zeichnung nicht dargestellt ist. Die endgültige Befestigung des Abdeckgehäuses 1 erfolgt mittels (später plombierter) Verbindungsschrauben im Bereich der Achsen 14. Eine Frontseite 15 des Abdeckgehäuses 1 enthält eine großflächige Ausnehmung 16, die mittels einer glasklaren Platte aus einem thermoplastischen Kunststoff, beispielsweise aus Policarbonat, verschlossen ist. In der Platte 2 ist eine Lupe 21 vorgesehen, die in Ableserichtung über der abzulesenden Meßskale beziehungsweise des abzulesenden Zählwerkes angespritzt ist. Es versteht sich, daß die Lupe sowohl linsen- als auch leistenförmig sein kann.

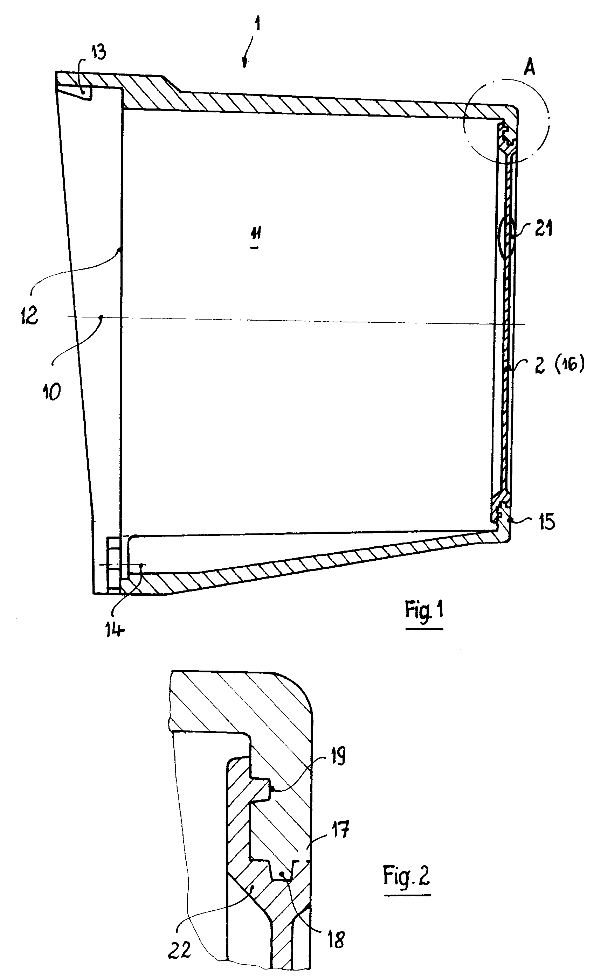

In der Fig. 2 ist zu erkennen, daß die Berandung 17 der Ausnehmung 16 mit einer (durchgängigen) Rippe 18 versehen ist, die von einem Randbereich 22 der Platte 2 überspritzt ist. Die Rippe 18 verhindert demzufolge die Lösung der Platte 2 aus dem Abdeckgehäuse 1, insbesondere in Verbindung mit einer umlaufenden Nut 19, die im Inneren der Frontseite 15 vorgesehen ist, wobei der Randbereich 22 der Platte 2 so weit nach außen gezogen ist, daß er die Nut 19 ausfüllt.

In der Fig. 2 ist ferner eindrucksvoll zu erkennen, daß der durchsichtige Verschluß des Abdeckgehäuses 1 im Bereich der Frontseite 15 nur eine ganz geringe Tiefenausdehnung erfordert und deshalb die Gesamtlänge des Abdeckgehäuses in Richtung seiner zentralen Achse 10 minimierbar ist.

## Patentansprüche

1. Abdeckgehäuse aus einem duroplastischen, dielektrischen Werkstoff, beispielsweise aus Phenolharz-Formmasse, zum Überfangen eines elektrischen Meß- oder Zählgerätes, mit einer durchsichtigen Frontseite zum Ablesen einer Meßskale oder eines Zählwerkes, insbesondere an einem Verbrauchszähler für elektrischen Strom,
dadurch gekennzeichnet, daß
in der Frontseite (15) eine Ausnehmung (16) mit einer glasklaren Platte (2) aus einem thermoplastischen Kunststoff wie beispielsweise Makrolon oder Plexiglas verschlossen ist, die in diese Frontseite (15), die Ausnehmung (16) verschließend, eingespritzt ist.

2. Abdeckgehäuse nach Anspruch 1, dadurch gekennzeichnet, daß eine Berandung (17) der Ausnehmung (16) mit an dem Abdeckgehäuse (1) angeformten, die Platte (2) verankernden Haltestücken (18,19) versehen ist, die von dem überspritzten Randbereich (22) der Platte (2) eingeschlossen sind und eine formschlüssige Arretierung bilden.

3. Abdeckgehäuse nach einem der Ansprüche 1 oder 2, dadurch gekennzeichnet, daß die Platte (2) in der Ausnehmung (16) so arretiert ist, daß sie daraus weder entfernbar noch wiedereinsetzbar ist, ohne daß die Platte (2) und/oder das Abdeckgehäuse (1) dabei sichtbar beschädigt oder zerstört werden.

4. Abdeckgehäuse nach einem der Ansprüche 2 oder 3, dadurch gekennzeichnet, daß in der Berandung (17) der Ausnehmung (16) Rippen (18) und/oder Nuten (19) vorgesehen sind, die von dem thermoplastischen Kunststoff überdeckt sind.

5. Abdeckgehäuse nach einem der Ansprüche 1 bis 4, dadurch gekennzeichnet, daß die Platte (2) im Bereich der abzulesenden Meßskale oder des abzulesenden Zählwerkes mit einer angeformten Lupe (21) versehen ist.

6. Abdeckgehäuse nach einem der Ansprüche 1 bis 5, dadurch gekennzeichnet, daß die Platte (2) eine Beschriftung, beispielsweise die Meßskale für das Meß- oder Zählgerät, aufweist.

7. Abdeckgehäuse nach Anspruch 6, dadurch gekennzeichnet, daß die Beschriftung auf der Innenseite der Platte (2) vorgesehen ist.

8. Abdeckgehäuse nach Anspruch 6, dadurch gekennzeichnet, daß die Beschriftung auf der Platte (2) erhaben zu deren Oberfläche vorgesehen ist

9. Abdeckgehäuse nach Anspruch 6, dadurch gekennzeichnet, daß die Beschriftung von der übrigen Platte (2) farblich abgehoben ist.
